# EUROPÄISCHE PATENTSCHRIFT

(11) **EP 3 227 975 B1**
(45) Veröffentlichungstag und Bekanntmachung des Hinweises auf die Patenterteilung: **10.04.2019**
(21) Anmeldenummer: 15790997.9
(22) Anmeldetag: 09.11.2015
(51) Int. Cl.: H01R 31/06, H05K 1/11, H01R 9/26

(54) **VERBINDUNGSADAPTER FÜR EINE ANSCHLUSSKLEMMENANORDNUNG**
CONNECTING ADAPTER FOR A CONNECTING TERMINAL ASSEMBLY
ADAPTATEUR DE LIAISON POUR ENSEMBLE DE BORNES DE RACCORDEMENT

(30) Priorität: 04.12.2014 DE 102014117868
(43) Veröffentlichungstag der Anmeldung: 11.10.2017
(73) Patentinhaber: Phoenix Contact GmbH & Co. KG, 32825 Blomberg (DE)
(72) Erfinder: SCHAPER, Elmar, 32676 Lügde (DE); SCHOPPE, Mathias, 37699 Fürstenberg (DE)
(74) Vertreter: Patentship Patentanwaltsgesellschaft mbH
(86) Internationale Anmeldenummer: PCT/EP2015/076092
(87) Internationale Veröffentlichungsnummer: WO 2016/087164

(56) Entgegenhaltungen:
- EP-A2- 0 709 932
- GB-A- 2 035 716
- JP-U- S50 145 462
- US-A- 4 936 785

## Beschreibung

Die vorliegende Erfindung betrifft einen Verbindungsadapter für eine Anschlussklemmenanordnung.

In der Prozesstechnik wird ein Betrieb eines Feldgerätes, wie eines Aktors oder eines Sensors, häufig mittels eines Steuerungssystems gesteuert. Hierzu umfasst das Feldgerät häufig eine Feldgeräteschnittstelle, welche über eine Anschlussleitung mit einer Steuerungssystemschnittstelle des Steuerungssystems verbunden wird.

Bei einer Steuerung eines Betriebs einer Mehrzahl von Feldgeräten werden die Feldgeräteschnittstellen der Feldgeräte häufig mittels der Mehrzahl von Anschlussleitungen über eine Anschlussklemmenanordnung, wie eine Reihenklemmenanordnung, mit der Steuerungssystemschnittstelle des Steuerungssystems verbunden. Hierzu werden häufig die Adern der Anschlussleitungen aufwändig einzeln mit elektrischen Anschlussklemmen, beispielsweise Schraubklemmen, der Anschlussklemmenanordnung elektrisch und mechanisch verbunden. Dies kann als unkomfortabel empfunden werden.

In der GB 2 035 716 A ist ein Verbindungsmittel für einen Anschlussblock offenbart, wobei das Verbindungsmittel eine fächerförmige Leiterplatte mit einer Anzahl von voneinander beabstandeten Zungen aufweist.

Es ist die der Erfindung zugrundeliegende Aufgabe, ein effizientes Konzept zum Anschließen eines elektrischen Gerätes an eine Anschlussklemmenanordnung anzugeben.

Diese Aufgabe wird durch den Gegenstand mit den Merkmalen nach dem unabhängigen Anspruch gelöst. Vorteilhafte Ausführungsformen der Erfindung sind Gegenstand der Figuren, der Beschreibung und der abhängigen Ansprüche.

Die vorliegende Erfindung basiert auf der Erkenntnis, dass die obige Aufgabe mittels eines Verbindungsadapters gelöst werden kann, welcher an eine Anzahl von elektrischen Anschlussklemmen einer Anschlussklemmenanordnung angeschlossen werden kann, und welcher eine elektrische Steckverbinderschnittstelle aufweist. Dadurch kann das elektrische Gerät, wie ein Feldgerät oder ein Steuerungssystem, effizient mittels eines vorkonfektionierten mehrpoligen Kabels mit einem oder mehreren angeschlossen Steckverbindern, zum Beispiel FLK, D-SUB, ELCO, Fujitusu FCN, IEC 60603 oder aus der Phoenix Contact Mini-Combicon-, Combicon- oder Power-Combicon-Familie der jeweils typischen Polzahl, einem sogenannten Systemkabel, an dem Verbindungsadapter angeschlossen werden, um das elektrische Gerät an der Anschlussklemmenanordnung anzuschließen. Beispielsweise weist das Systemkabel einen FLK-Steckverbinder mit den typischen Polzahlen 14, 16, 20, 24, 26, 34, 40, 50, 60 oder 64, eine High Density (HD) Variante eines FLK-Steckverbinders, einen D-Sub-Steckverbinder mit den typischen Polzahlen 9, 15, 25, 37, 50 oder 62, eine HD-Variante eines D-Sub-Steckverbinders, einen ELCO-Steckverbinder mit den typischen Polzahlen 20, 38, 56, 90 oder 120, einen 40 poligen Fujitsu FCN Steckverbinder, einen IEC 60603 Steckverbinder, einen Steckverbinder der Phoenix Contact (PxC) Mini-Combicon Familie, der PxC Combicon Familie oder der PxC Power-Combicon Familie mit 2 bis 20 Polen und/oder einen sonstigen PxC-Steckverbinder auf.

Gemäß Anspruch 1 wird die Aufgabe durch einen Verbindungsadapter für eine Anschlussklemmenanordnung, wobei die Anschlussklemmenanordnung eine Anzahl von elektrischen Anschlussklemmen aufweist, gelöst, mit: einer Leiterplatte mit einer kammförmigen Leitungsstruktur mit der Anzahl von Kammzinken, wobei die Kammzinken jeweils eine elektrische Kontaktfläche aufweisen; einer elektrischen Steckverbinderschnittstelle für einen Steckverbinder, wobei die elektrische Steckverbinderschnittstelle elektrische Anschlüsse aufweist, welche mit den elektrischen Kontaktflächen der Kammzinken elektrisch verbunden sind, und wobei die elektrische Steckverbinderschnittstelle auf der Leiterplatte angeordnet ist. Dadurch wird der Vorteil erreicht, dass ein elektrisches Gerät, wie ein Feldgerät, eine Systemsteuerung oder eine Leittechnik, mittels eines Systemkabels, welches mit der elektrischen Steckverbinderschnittstelle verbindbar ist, effizient und kostengünstig an der Anschlussklemmenanordnung angeschlossen werden kann.

Die Anschlussklemmenanordnung kann eine Reihenklemmenanordnung, insbesondere eine in einem Schaltschrank angeordnete Reihenklemmenanordnung, sein. Ferner kann die Anzahl 1, 2, 3, 4, 5, 6, 7, 8, 9, 10, 15, 20, 25, 30, 35, 40, 45 oder 50. Gemäß einer Ausführungsform kann die Anzahl eine dem eingesetzten Steckverbinder entsprechende Anzahl oder eine beliebige Polzahl betragen. Die elektrischen Anschlussklemmen können durch Schraubklemmen gebildet sein. Hierbei kann durch Verschrauben der Schraubklemmen ferner eine mechanische Fixierung des Verbindungsadapters an der Anschlussklemmenanordnung erreicht werden.

Die kammförmige Leitungsstruktur kann durch Leiterbahnen auf der Leiterplatte gebildet sein. Ferner können die elektrischen Kontaktflächen jeweils durch eine Kupferschicht gebildet sein. Beispielsweise sind die Kammzinken jeweils auf einer Seite, auf zwei Seiten oder auf allen Seiten mit Kupfer beschichtet.

Die elektrische Steckverbinderschnittstelle kann eine Schnittstelle zum Verbinden mit einem FLK-Steckverbinder, einer HD-Variante eines FLK-Steckverbinders, einem D-Sub-Steckverbinder, einer HD-Variante eines D-Sub-Steckverbinders, einem ELCO-Steckverbinder, einem Fujitsu FCN Steckverbinder, einem IEC 60603 Steckverbinder, einem Steckverbinder der PxC Mini-Combicon Familie, der PxC Combicon Familie oder der PxC Power-Combicon Familie und/oder einem sonstigen PxC-Steckverbinder umfassen.

In einer vorteilhaften Ausführungsform des Verbindungsadapters ist jeweils eine elektrische Kontaktfläche eines Kammzinkens der Leiterplatte mit jeweils einem elektrischen Anschluss der elektrischen Steckverbinderschnittstelle elektrisch verbunden. Dadurch wird der Vorteil erreicht, dass elektrische Signale von einem elektrischen Anschluss der elektrischen Steckverbinderschnittstelle an eine elektrische Kontaktfläche eines Kammzinkens und damit an die elektrische Anschlussklemme, in welche der Kammzinken eingeführt ist, übertragen werden können. Beispielsweise ist jeder elektrische Anschluss der elektrischen Steckverbinderschnittstelle mit genau einer elektrischen Kontaktfläche eines Kammzinkens elektrisch verbunden.

In einer weiteren vorteilhaften Ausführungsform des Verbindungsadapters ist der Verbindungsadapter ausgebildet mit einem Steckverbinder, insbesondere mit einem FLK-Steckverbinder oder einem D-Sub-Steckverbinder, wobei der Steckverbinder mit den elektrischen Anschlüssen des elektrischen Steckverbinderanschlusses elektrisch verbunden ist. Dadurch wird der Vorteil erreicht, dass ein Systemkabel effizient an dem Verbindungsadapter angeschlossen werden kann. Der elektrische Steckverbinder kann stoffschlüssig mit der Leiterplatte verbunden sein, insbesondere durch Verlöten mit den elektrischen Anschlüssen des elektrischen Steckverbinderanschlusses.

Ferner kann der Steckverbinder eine HD-Variante eines FLK-Steckverbinders, eine HD-Variante eines D-Sub-Steckverbinders, ein ELCO-Steckverbinder, ein Fujitsu FCN Steckverbinder, ein IEC 60603 Steckverbinder, ein Steckverbinder der PxC Mini-Combicon Familie, der PxC Combicon Familie oder der PxC Power-Combicon Familie oder ein sonstiger PxC-Steckverbinder sein.

In einer weiteren vorteilhaften Ausführungsform des Verbindungsadapters ist der Steckverbinder kraftschlüssig oder formschlüssig mit der Leiterplatte verbunden. Dadurch wird der Vorteil erreicht, dass der Steckverbinder an der Leiterplatte fixiert werden kann. Der Steckverbinder kann mit der Leiterplatte verschraubt oder verrastet sein. Hierzu kann die Leiterplatte eine Öffnung zum Durchführen einer Schraube und/oder eine Rastöffnung aufweisen.

In einer weiteren vorteilhaften Ausführungsform des Verbindungsadapters sind die Kammzinken der Leiterplatte rechteckförmig oder abgerundet. Dadurch wird der Vorteil erreicht, dass die Kammzinken besonders leicht in die elektrischen Anschlussklemmen eingeführt werden können.

In einer weiteren vorteilhaften Ausführungsform des Verbindungsadapters sind benachbarte Kammzinken der Leiterplatte durch eine Ausnehmung, insbesondere durch eine rechteckförmige oder abgerundete Ausnehmung, beabstandet, welche ausgebildet ist, einen Gehäusesteg der Anschlussklemmenanordnung zwischen benachbarten elektrischen Anschlussklemmen aufzunehmen. Dadurch wird der Vorteil erreicht, dass die Kammzinken formschlüssig in den elektrischen Anschlussklemmen der Anschlussklemmenanordnung aufgenommen werden können.

In einer weiteren vorteilhaften Ausführungsform des Verbindungsadapters weist eine elektrische Kontaktfläche eines Kammzinkens der Anzahl der Kammzinken der Leiterplatte eine Rechteckform, eine Quadratform, eine Kreisform, eine Dreiecksform oder eine Fünfeckform auf. Dadurch wird der Vorteil erreicht, dass eine elektrische Kontaktierung der elektrischen Kontaktfläche mit einem Klemmkörper oder einer Klemmfläche einer elektrischen Anschlussklemme optimiert werden kann.

In einer weiteren vorteilhaften Ausführungsform des Verbindungsadapters weist ein Kammzinken eine Mehrzahl von elektrischen Kontaktflächen auf, welche über elektrisch leitende Stege, insbesondere über auf der Leiterplatte angeordnete Kupferstege, miteinander elektrisch leitend verbunden sind. Dadurch wird der Vorteil erreicht, dass eine elektrische Kontaktierung der elektrischen Kontaktfläche mit einem Klemmkörper oder einer Klemmfläche einer elektrischen Anschlussklemme weiter optimiert werden kann. Beispielsweise beträgt die Mehrzahl 2, 3, 4, 5, 6, 7, 8, 9, 10, 15, 20, 24, 25, 30, 35, 40, 45 oder 50. Gemäß einer Ausführungsform kann die Mehrzahl eine dem eingesetzten Steckverbinder entsprechende Anzahl oder eine beliebige Polzahl betragen. Ferner kann eine elektrische Kontaktfläche der Mehrzahl der elektrischen Kontaktflächen eine Rechteckform, eine Quadratform, eine Kreisform, eine Dreiecksform oder eine Fünfeckform aufweisen.

Erfindungsgemäß ist der Verbindungsadapter ausgebildet mit einer elektrischen Signalübertragungsschnittstelle, insbesondere einer in oder an der Leiterplatte gebildeten elektrischen Signalübertragungsschnittstelle, wobei die elektrische Signalübertragungsschnittstelle mit der elektrischen Steckverbinderschnittstelle elektrisch verbunden ist. Dadurch wird der Vorteil erreicht, dass der Verbindungsadapter an einem weiteren elektrischen Gerät, insbesondere an einem weiteren Verbindungsadapter, angeschlossen werden kann. Gemäß einer Ausführungsform kann die elektrische Signalübertragungsschnittstelle eine Anzahl von elektrischen Anschlüssen umfassen, welche durch Durchbruchkontaktierungen in der Leiterplatte gebildet sind. Beispielsweise beträgt die Anzahl 1, 2, 3, 4, 5, 6, 7, 8, 9, 10, 15, 20, 25, 30, 35, 40, 45 oder 50. Gemäß einer Ausführungsform kann die Anzahl eine dem eingesetzten Steckverbinder entsprechende Anzahl oder eine beliebige Polzahl betragen. Gemäß einer weiteren Ausführungsform kann die elektrische Signalübertragungsschnittstelle eine Anzahl von elektrischen Anschlüssen umfassen, welche durch elektrische Kontaktflächen an, insbesondere an einem Rand, der Leiterplatte gebildet sind. Beispielsweise beträgt die Anzahl 1, 2, 3, 4, 5, 6, 7, 8, 9, 10, 15, 20, 25, 30, 35, 40, 45 oder 50. Gemäß einer Ausführungsform kann die Anzahl eine dem eingesetzten Steckverbinder entsprechende Anzahl oder eine beliebige Polzahl betragen.

Erfindungsgemäß ist der Verbindungsadapter ausgebildet mit: einer weiteren Leiterplatte mit einer kammförmigen Leitungsstruktur mit einer Mehrzahl von Kammzinken, wobei die Kammzinken jeweils eine elektrische Kontaktfläche aufweisen; und einer weiteren elektrischen Signalübertragungsschnittstelle, insbesondere einer in oder an der weiteren Leiterplatte gebildeten weiteren elektrischen Signalübertragungsschnittstelle, wobei die weitere Signalübertragungsschnittstelle mit der elektrischen Signalübertragungsschnittstelle der Leiterplatte und mit den elektrischen Kontaktflächen der Kammzinken der weiteren Leiterplatte elektrisch verbunden ist. Dadurch wird der Vorteil erreicht, dass das elektrische Gerät mittels des Verbindungsadapters an einer mehrstöckigen Anschlussklemmenanordnung, insbesondere an einer zweistöckigen Reihenklemme, angeschlossen werden kann. Hierbei können die Kammzinken der weiteren Leiterplatte und deren elektrische Kontaktflächen wie bei der Leiterplatte ausgebildet sein. Ferner kann die weitere elektrische Signalübertragungsschnittstelle wie die elektrische Signalübertragungsschnittstelle ausgebildet sein.

In einer weiteren vorteilhaften Ausführungsform des Verbindungsadapters ist die weitere Signalübertragungsschnittstelle über eine Sandwichleiste oder einen flexiblen Leiterplattenanteil, insbesondere einen bogenförmigen oder S-förmigen flexiblen Leiterplattenanteil, mit der elektrischen Signalübertragungsschnittstelle elektrisch verbunden. Dadurch wird der Vorteil erreicht, dass der Verbindungsadapter besonders kostengünstig gefertigt werden kann.

Die Sandwichleiste kann eine Mehrzahl von Kontaktstiften umfassen. Beispielsweise beträgt die Mehrzahl 2, 3, 4, 5, 6, 7, 8, 9, 10, 15, 20, 25, 30, 35, 40, 45 oder 50. Gemäß einer Ausführungsform kann die Mehrzahl eine dem eingesetzten Steckverbinder entsprechende Anzahl oder eine beliebige Polzahl betragen. Ferner kann der flexible Leiterplattenanteil eine Starflex-Leiterplatte und/oder eine Polyamid-Leiterplatte umfassen. Beispielsweise werden die Leiterplatte und der flexible Leiterplattenanteil laminiert oder verpresst.

In einer weiteren vorteilhaften Ausführungsform des Verbindungsadapters ist jeweils eine elektrische Kontaktfläche eines Kammzinkens der weiteren Leiterplatte mit jeweils einem elektrischen Anschluss der elektrischen Steckverbinderschnittstelle elektrisch verbunden. Dadurch wird der Vorteil erreicht, dass elektrische Signale von einem elektrischen Anschluss der elektrischen Steckverbinderschnittstelle an eine elektrische Kontaktfläche eines Kammzinkens und damit an die elektrische Anschlussklemme, in welche der Kammzinken eingeführt ist, übertragen werden können. Beispielsweise ist jeder elektrische Anschluss der elektrischen Steckverbinderschnittstelle mit genau einer elektrischen Kontaktfläche eines Kammzinkens elektrisch verbunden.

Erfindungsgemäß sind die Leiterplatte und die weitere Leiterplatte übereinander und voneinander beabstandet angeordnet. Dadurch wird der Vorteil erreicht, dass der Verbindungsadapter an eine Anschlussklemmenanordnung mit übereinander angeordneten Reihen von elektrischen Anschlussklemmen angeschlossen werden kann.

Erfindungsgemäß sind die Leiterplatte und die weitere Leiterplatte mittels eines Distanzbolzens voneinander beabstandet angeordnet. Dadurch wird der Vorteil erreicht, dass eine mechanische Belastbarkeit des Verbindungsadapters erhöht werden kann. Der Distanzbolzen kann ein Kunststoffbolzen sein. Ferner kann der Distanzbolzen mit der Leiterplatte und/oder der weiteren Leiterplatte verschraubt sein.

In einer weiteren vorteilhaften Ausführungsform des Verbindungsadapters ist der Verbindungsadapter ausgebildet mit: einer weiteren Anzahl von weiteren Leiterplatten, wobei jede Leiterplatte eine kammförmige Leitungsstruktur mit einer Mehrzahl von Kammzinken mit jeweils einer elektrische Kontaktfläche sowie eine elektrische Signalübertragungsschnittstelle aufweist, und wobei die elektrischen Kontaktflächen zumindest einer Leiterplatte der weiteren Anzahl der weiteren Leiterplatten mit der elektrischen Signalübertragungsschnittstelle dieser Leiterplatte verbunden sind. Dadurch wird der Vorteil erreicht, dass der Verbindungsadapter an einer mehrstöckigen Anschlussklemmenanordnung, insbesondere an einer mehrstöckigen Reihenklemme, angeschlossen werden kann.

Die Kammzinken der weiteren Anzahl der weiteren Leiterplatten und deren elektrischen Kontaktflächen können wie bei der Leiterplatte ausgebildet sein. Ferner kann die weitere Anzahl 1, 2, 3, 4, 5, 6, 7, 8, 9 oder 10 betragen. Gemäß einer Ausführungsform kann die weitere Anzahl eine dem eingesetzten Steckverbinder entsprechende Anzahl oder eine beliebige Polzahl betragen. Die Mehrzahl der Kammzinken kann ferner 2, 3, 4, 5, 6, 7, 8, 9, 10, 15, 20, 25, 30, 35, 40, 45 oder 50 betragen. Gemäß einer Ausführungsform kann die Mehrzahl eine dem eingesetzten Steckverbinder entsprechende Anzahl oder eine beliebige Polzahl betragen. Ferner können die weiteren elektrischen Signalübertragungsschnittstellen wie die elektrische Signalübertragungsschnittstelle ausgebildet sein.

Die elektrischen Signalschnittstellen benachbarter Leiterplatten können, insbesondere mittels einer Sandwichleiste oder eines flexiblen Leiterplattenabschnitts, elektrisch verbunden sein, um die elektrischen Kontaktflächen mit den elektrischen Anschlüssen der elektrischen Steckverbinderschnittstelle elektrisch zu verbinden. Ferner können benachbarte Leiterplatten der weiteren Anzahl der weiteren Leiterplatten übereinander und beabstandet, insbesondere mittels eines Distanzbolzens beabstandet, angeordnet sein.

In einer weiteren vorteilhaften Ausführungsform des Verbindungsadapters ist jeweils eine elektrische Kontaktfläche eines Kammzinkens der weiteren Anzahl der weiteren Leiterplatten mit jeweils einem elektrischen Anschluss der elektrischen Steckverbinderschnittstelle elektrisch verbunden. Dadurch wird der Vorteil erreicht, dass elektrische Signale von einem elektrischen Anschluss der elektrischen Steckverbinderschnittstelle an eine elektrische Kontaktfläche eines Kammzinkens und damit an die elektrische Anschlussklemme, in welche der Kammzinken eingeführt ist, übertragen werden können. Beispielsweise ist jeder elektrische Anschluss der elektrischen Steckverbinderschnittstelle mit genau einer elektrischen Kontaktfläche eines Kammzinkens elektrisch verbunden.

Ausführungsbeispiele der Erfindung sind in den Zeichnungen dargestellt und werden im Folgenden näher beschrieben.

Es zeigen:
- Fig. 1: eine schematische Darstellung eines Verbindungsadapters gemäß einer Ausführungsform;
- Fig. 2: eine schematische Darstellung des Verbindungsadapters gemäß einer weiteren Ausführungsform;
- Fig. 3: eine schematische Darstellung des Verbindungsadapters gemäß einer weiteren Ausführungsform;
- Fig. 4: eine perspektivische Ansicht des Verbindungsadapters gemäß einer weiteren Ausführungsform;
- Fig. 5: eine Anordnung mit dem in der Fig. 4 gezeigten Verbindungsadapter und einer Anschlussklemmenanordnung;
- Fig. 6: eine Aufsicht auf eine doppelstöckige Reihenklemme;
- Fig. 7: eine Anordnung mit zwei der in der Fig. 4 gezeigten Verbindungsadaptern und einer Anschlussklemmenanordnung;
- Figs. 8 bis 10: verschiedene Ausführungsformen einer elektrischen Kontaktfläche eines Kammzinkens;
- Fig. 11A: eine Aufsicht auf die Leiterplatte gemäß einer Ausführungsform;
- Fig. 11B: eine Aufsicht auf eine weitere Leiterplatte gemäß einer Ausführungsform;
- Fig. 12: eine Querschnittsansicht einer Anordnung mit einer Mehrzahl von doppelstöckigen Reihenklemmen und dem Verbindungsadapter gemäß einer weiteren Ausführungsform;
- Fig. 13: eine perspektivische Ansicht der in Fig. 12 gezeigten Anordnung;
- Fig. 14: eine perspektivische Ansicht der in Fig. 12 gezeigten Anordnung mit einem weiteren Verbindungsadapter;
- Fig. 15: eine schematische Darstellung des Verbindungsadapters gemäß einer weiteren Ausführungsform;
- Fig. 16: eine Querschnittsansicht einer Anordnung mit der in Fig. 6 gezeigten doppelstöckigen Reihenklemme und dem Verbindungsadapter gemäß der in Fig. 15 gezeigten Ausführungsform;
- Fig. 17: eine Querschnittsansicht einer Anordnung mit einer dreistöckigen Reihenklemme und dem Verbindungsadapter gemäß einer weiteren Ausführungsform; und
- Fig. 18: eine Querschnittsansicht einer Anordnung mit einer vierstöckigen Reihenklemme und dem Verbindungsadapter gemäß einer weiteren Ausführungsform.

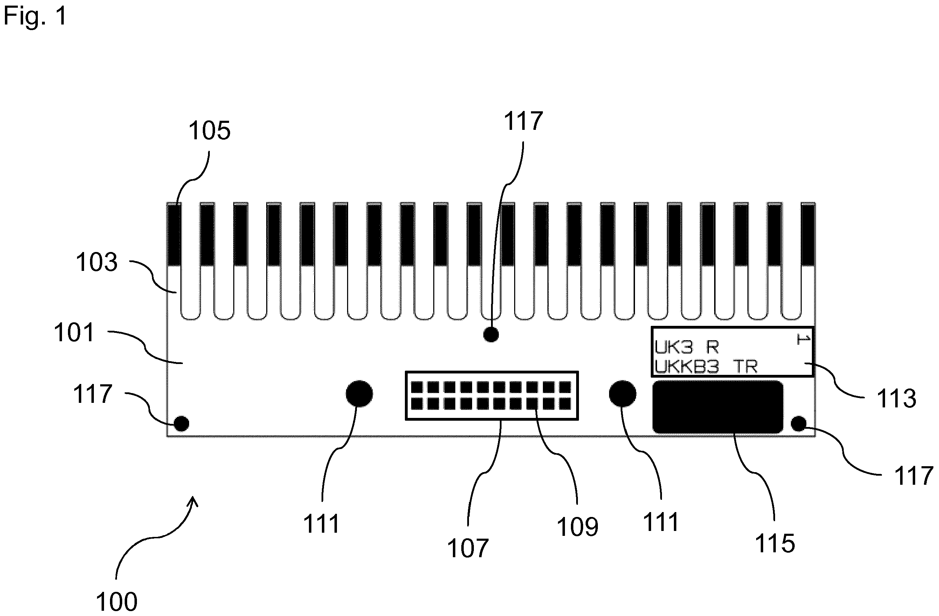

Fig. 1 zeigt eine schematische Darstellung eines Verbindungsadapters 100 gemäß einer Ausführungsform. Der Verbindungsadapter 100 umfasst eine Leiterplatte 101 mit zwanzig Kammzinken 103, welche jeweils eine elektrische Kontaktfläche 105 aufweisen, einer elektrische Steckverbinderschnittstelle 107, welche zwanzig elektrische Anschlüsse 109 aufweist, zwei Öffnungen 111, mittels welcher ein Steckverbinder kraftschlüssig oder formschlüssig mit der Leiterplatte 101 verbunden werden kann, einem Beschriftungsfeld 113, einem Markierungsfeld 115 und drei Bohrungen 117.

Der Verbindungsadapter 100 für eine Anschlussklemmenanordnung, wobei die Anschlussklemmenanordnung eine Anzahl von elektrischen Anschlussklemmen aufweist, kann ausgebildet sein mit: der Leiterplatte 101 mit einer kammförmigen Leitungsstruktur mit der Anzahl der Kammzinken 103, wobei die Kammzinken 103 jeweils eine elektrische Kontaktfläche 105 aufweisen; der elektrischen Steckverbinderschnittstelle 107 für einen Steckverbinder, wobei die elektrische Steckverbinderschnittstelle 107 elektrische Anschlüsse 109 aufweist, welche mit den elektrischen Kontaktflächen 105 der Kammzinken 103 elektrisch verbunden sind, und wobei die elektrische Steckverbinderschnittstelle 107 auf der Leiterplatte 101 angeordnet ist.

Die Anschlussklemmenanordnung kann eine Reihenklemmenanordnung, insbesondere eine in einem Schaltschrank angeordnete Reihenklemmenanordnung, sein. Ferner kann die Anzahl 1, 2, 3, 4, 5, 6, 7, 8, 9, 10, 15, 20, 25, 30, 35, 40, 45 oder 50 betragen. Gemäß einer Ausführungsform kann die Anzahl eine dem eingesetzten Steckverbinder entsprechende Anzahl oder eine beliebige Polzahl betragen. Die elektrischen Anschlussklemmen können durch Schraubklemmen gebildet sein. Hierbei kann durch Verschrauben der Schraubklemmen ferner eine mechanische Fixierung des Verbindungsadapters 100 an der Anschlussklemmenanordnung erreicht werden.

Die kammförmige Leitungsstruktur kann durch Leiterbahnen auf der Leiterplatte 101 gebildet sein. Ferner können die elektrischen Kontaktflächen 105 jeweils durch eine Kupferschicht gebildet sein. Beispielsweise sind die Kammzinken 103 jeweils auf einer Seite, auf zwei Seiten oder auf allen Seiten mit Kupfer beschichtet.

Die elektrische Steckverbinderschnittstelle 107 kann eine Schnittstelle zum Verbinden mit einem FLK-Steckverbinder, einer HD-Variante eines FLK-Steckverbinders, einem D-Sub-Steckverbinder, einer HD-Variante eines D-Sub-Steckverbinders, einem ELCO-Steckverbinder, einem Fujitsu FCN Steckverbinder, einem IEC 60603 Steckverbinder, einem Steckverbinder der PxC Mini-Combicon Familie, der PxC Combicon Familie oder der PxC Power-Combicon Familie und/oder einem sonstigen PxC-Steckverbinder umfassen.

Gemäß einer Ausführungsform kann die Leiterplatte 101 eine FR4-Leiterplatte sein.

Gemäß einer weiteren Ausführungsform können zur Kontaktierung einer Steuerungsseite einer Anschlussklemmenanordnung, wie einer Reihenklemme, verschiedene, beispielsweise dem Raster der Anschlussklemmenanordnung angepasste, möglichst universelle und/oder speziell designten Leiterplatten 101 für verschiedene Polzahlen, insbesondere systemkabelanhängig, eingesetzt werden. Dadurch kann ein schneller und vertauschungssicherer Anschluss eines elektrischen Geräts, wie einer Steuerung, an die Anschlussklemmenanordnung ermöglicht werden.

Gemäß einer weiteren Ausführungsform können die Kammzinken 103 der Leiterplatte 101 etwas schmaler als die Klemmräume der elektrischen Anschlussklemmen ausgeführt sein, um kleine Abweichungen in dem Raster der Anschlussklemmenanordnung ausgleichen zu können.

Gemäß einer weiteren Ausführungsform können die elektrischen Anschlussklemmen jeweils einen Klemmkörper umfassen, welcher gegen einen Kammzinken 103 anpressbar ist, um den Kammzinken 103 mechanisch an der elektrischen Anschlussklemme zu fixieren und um die elektrische Anschlussfläche 105 des Kammzinken 103, beispielsweise über eine Klemmfläche, elektrisch zu kontaktieren. Beispielsweise ist der Klemmkörper aus verzinktem Stahl gefertigt.

Gemäß einer weiteren Ausführungsform kann eine Mehrzahl von Verbindungsadaptern 100 an der Anschlussklemmenanordnung angeschlossen werden. Hierzu können die Verbindungsadapter 100 der Mehrzahl der Verbindungsadapter 100 in verschiedenen Adaptierungen, wie Varianten, ausgeführt werden, um den Anschluss an die Anschlussklemmenanordnung zu erleichtern. Dies kann insbesondere bei einer mehrstöckigen Anschlussklemmenanordnung vorteilhaft sein. Hierzu können in den verschiedenen Adaptierungen des Verbindungsadapters 100 die Kammzinken 105 versetzt angeordnet werden, um den Zugang mit einem Werkzeug, wie einem Schraubendreher, zu einer Ebene einer mehrstöckigen Anschlussklemmenanordnung zu ermöglichen. Ferner können die verschiedenen Adaptierungen des Verbindungsadapters 100 mit links, rechts, oben, mitte, unten sowie allen daraus resultierende Kombinationen bezeichnet werden. Zur besseren Identifikation der jeweils einzusetzenden Adaptierung des Verbindungsadapters 100 kann die zugehörige Bezeichnung, wie eine Reihenklemmenbezeichnung, in dem Beschriftungsfeld 113 auf der Leiterplatte 101 vermerkt werden. Ferner kann in dem Markierungsfeld 115 eine Markierung für linke und rechte Adaptierung, beispielsweise mittels unterschiedlicher Farben, aufgebracht werden.

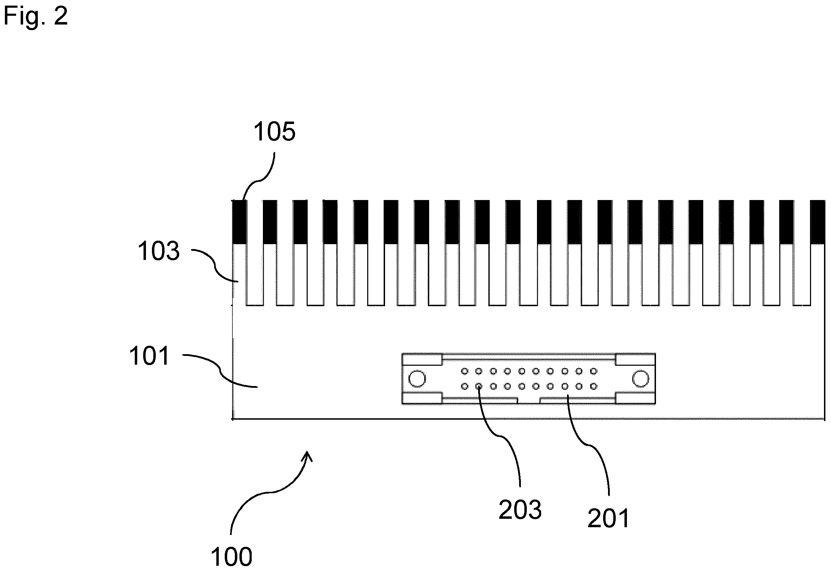

Fig. 2 zeigt eine schematische Darstellung des Verbindungsadapters 100 gemäß einer weiteren Ausführungsform. Der Verbindungsadapter 100 umfasst die Leiterplatte 101 mit zwanzig Kammzinken 103, welche jeweils eine elektrische Kontaktfläche 105 aufweisen, und einen Steckverbinder 201, welcher zwanzig elektrische Anschlüsse 203 umfasst und an der nicht abgebildeten elektrischen Steckverbinderschnittstelle 107 angeschlossen ist.

Der Steckverbinder 201 kann als ein FLK-Steckverbinder oder als ein Systemsteckverbinder ausgebildet sein. Ferner kann eine Breite der Kammzinken103 2mm und ein Abstand zweier benachbarte Kammzinken 103 3mm betragen. Eine Länge der Kammzinken 103 kann ferner 18mm betragen. Eine Breite der Leiterplatte 101 kann ferner 105mm betragen. Ferner kann eine Höhe der Leiterplatte 101 ohne die Kammzinken 103 20mm betragen.

Gemäß einer Ausführungsform kann ein Rastermaß der Kammzinken abhängig von den zu adaptierenden Reihenklemmen gewählt werden. Das Rastermaß kann in allen denkbaren Abständen, insbesondere mit einer minimalen Zinkenbreite von 1mm und/oder einem minimalen Abstand zwischen benachbarten Zinken von 1mm, und Zinkenbreiten ausgeführt sein.

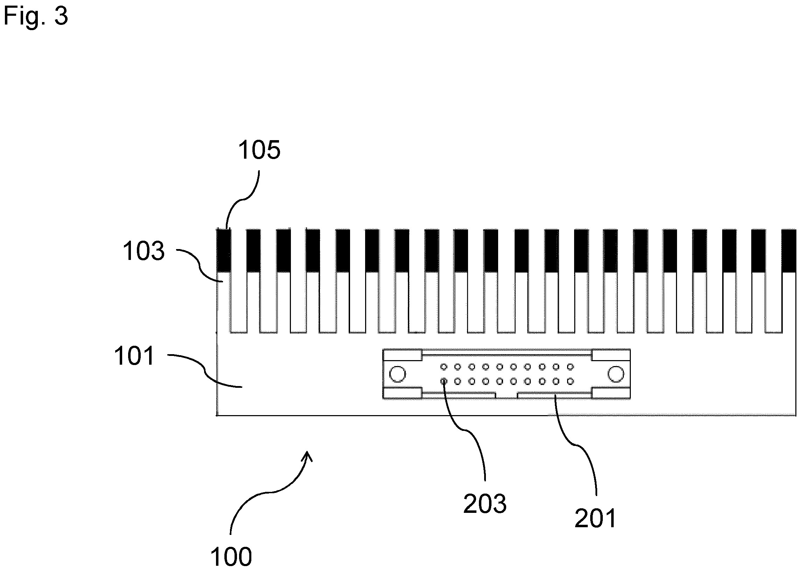

Fig. 3 zeigt eine schematische Darstellung des Verbindungsadapters 100 gemäß einer weiteren Ausführungsform. Der in der Fig. 3 abgebildete Verbindungsadapter 100 unterscheidet sich von dem in der Fig. 2 abgebildeten Verbindungsadapter 100 lediglich durch die Höhe der Leiterplatte 101 ohne die Kammzinken 103. Diese kann bei dem in der Fig. 3 abgebildeten Verbindungsadapter 100 15mm betragen.

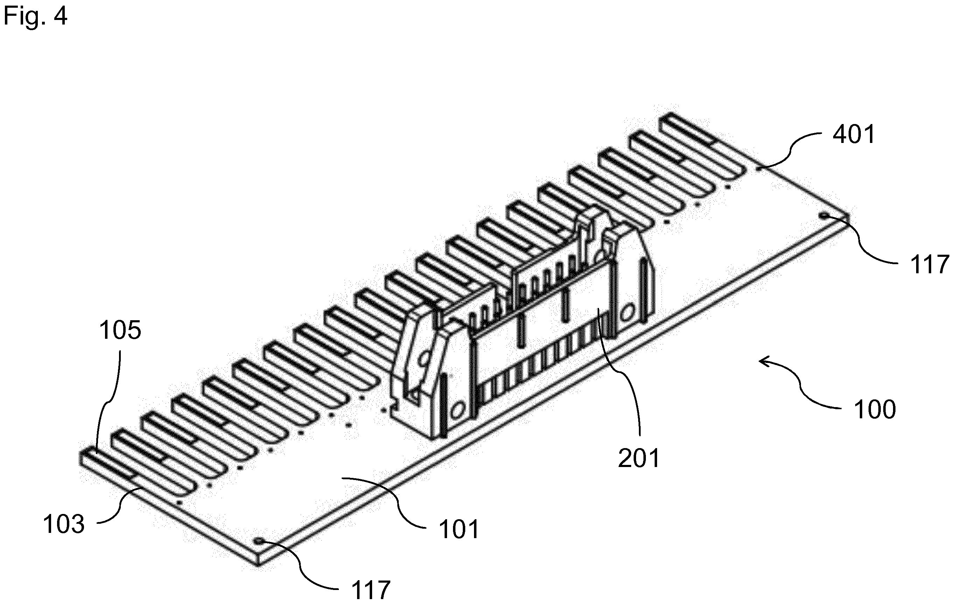

Fig. 4 zeigt eine perspektivische Ansicht des Verbindungsadapters 100 gemäß einer weiteren Ausführungsform. Der Verbindungsadapter 100 umfasst die Leiterplatte 101 mit zwanzig Kammzinken 103, welche jeweils eine elektrische Kontaktfläche 105 aufweisen, und den Steckverbinder 201. Ferner weist die Leiterplatte 101 zwei Bohrungen 117 und eine Mehrzahl von Bohrungen 401 auf. Beispielsweise kann mittels der Bohrungen 401 eine Durchkontaktierung für nicht abgebildete Leiterbahnen durch eine Lage der Leiterplatte 101 realisiert werden.

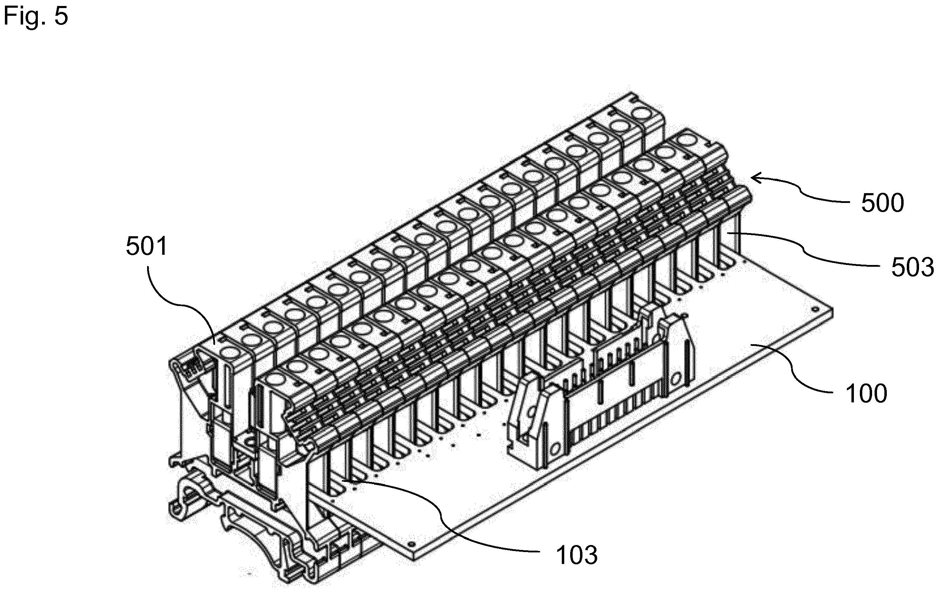

Fig. 5 zeigt eine Anordnung mit dem in der Fig. 4 gezeigten Verbindungsadapter 100 und einer Anschlussklemmenanordnung 500. Die Anschlussklemmenanordnung 500 umfasst zwanzig in Reihe angeordnete Reihenklemmen 501, welche auf beiden Seiten jeweils eine elektrische Anschlussklemme 503 aufweisen. Die Kammzinken 103 des Verbindungsadapters 100 sind in die elektrischen Anschlussklemmen 501 eingeführt.

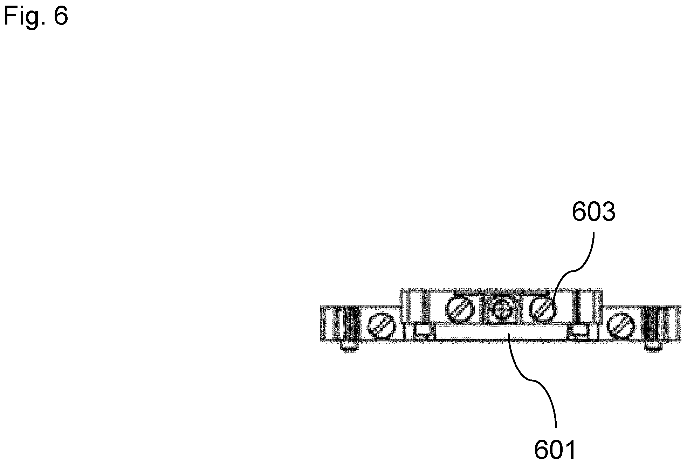

Fig. 6 zeigt eine Aufsicht auf eine doppelstöckige Reihenklemme 601. Die doppelstöckige Reihenklemme 601 ist als eine Schraubklemme ausgebildet und umfasst vier Schrauben 603. Durch Anziehen der Schrauben 603 kann ein in die zugehörige nicht abgebildete elektrische Anschlussklemme 503 eingeführter nicht abgebildeter Kammzinken 103 mit der elektrischen Anschlussklemme 503 mechanisch fixiert und die elektrische Kontaktfläche 105 des Kammzinkens 103 mit der elektrischen Anschlussklemme 503 elektrisch verbunden werden.

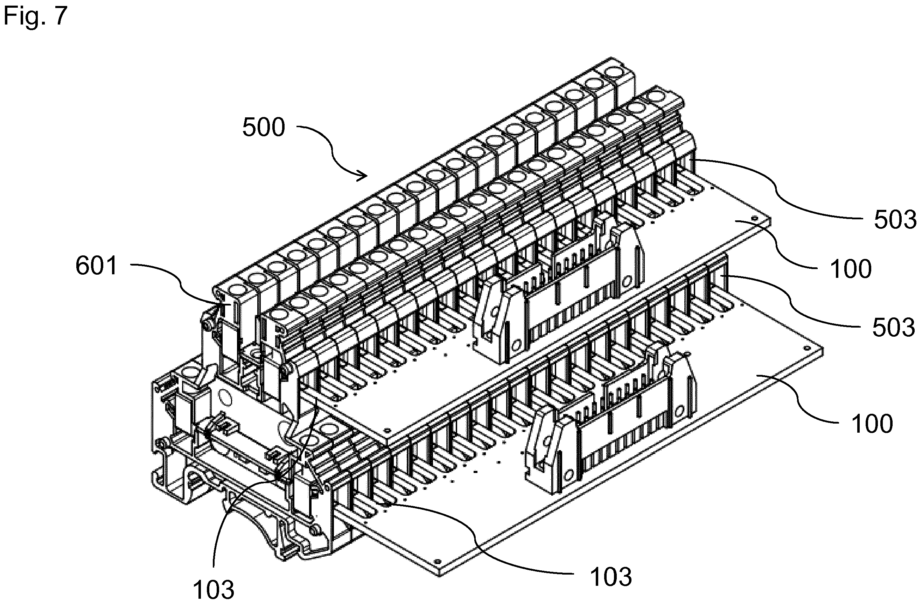

Fig. 7 zeigt eine Anordnung mit zwei der in der Fig. 4 gezeigten Verbindungsadaptern 100 und einer Anschlussklemmenanordnung 500. Die Anschlussklemmenanordnung 500 umfasst zwanzig doppelstöckige Reihenklemmen 601, welche auf beiden Seiten jeweils zwei elektrische Anschlussklemmen 503 aufweisen. Die Kammzinken 103 der Verbindungsadapter 100 sind in die elektrischen Anschlussklemmen 503 eingeführt.

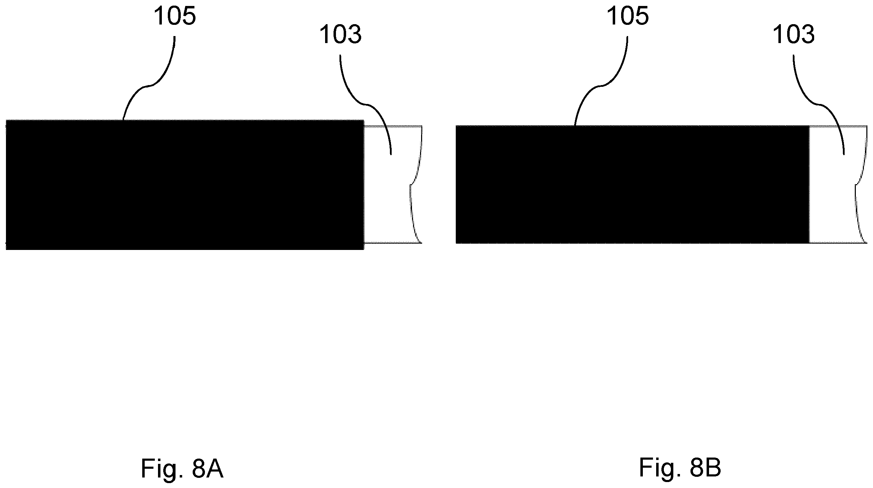

Figs. 8 bis 10 zeigen verschiedene Ausführungsformen einer elektrischen Kontaktfläche 105 eines Kammzinkens 103. Fig. 8A zeigt eine Seitenansicht eines Kammzinkens 103, dessen elektrische Kontaktfläche 105 durch eine vollflächige vierseitige Kupferbeschichtung des Kammzinkens 103 gebildet ist. Eine Dicke der Kupferbeschichtung kann 35µm bis 105µm betragen. Ferner kann eine Dicke des Kammzinkens 103 1,5mm oder mehr betragen. Fig. 8B zeigt eine Aufsicht auf den in Fig. 8A abgebildeten Kammzinken 103.

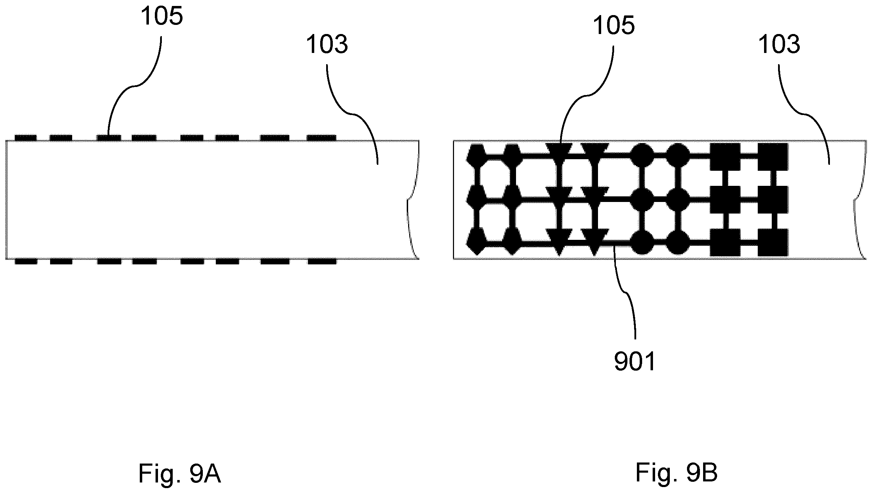

Fig. 9A zeigt eine Seitenansicht eines Kammzinkens 103 mit einer Mehrzahl von elektrischen Kontaktflächen 105, welche an einer Oberseite und einer Unterseite des Kammzinkens 103 angeordnet ist. Die Mehrzahl der elektrischen Kontaktflächen 105 kann durch eine Kupferbeschichtung mit einer Dicke von 35µm bis 105µm gebildet sein. Ferner kann eine Dicke des Kammzinkens 103 1,5mm oder mehr betragen. Fig. 9B zeigt eine Aufsicht auf den in Fig. 9A abgebildeten Kammzinken 103. Die elektrischen Kontaktflächen 105 der Mehrzahl der elektrischen Kontaktflächen 105 sind mittels elektrisch leitender Stege 901 verbunden und weisen unterschiedliche geometrische Formen auf. Die geometrischen Formen sind Quadratformen, Kreisformen, Dreiecksformen und Fünfeckformen. Durch die Wahl der geometrischen Formen kann eine Kontaktierung der elektrischen Anschlussklemme 503 optimiert werden, insbesondere bei Korrosion oder bei einer Bildung von Oxidschichten.

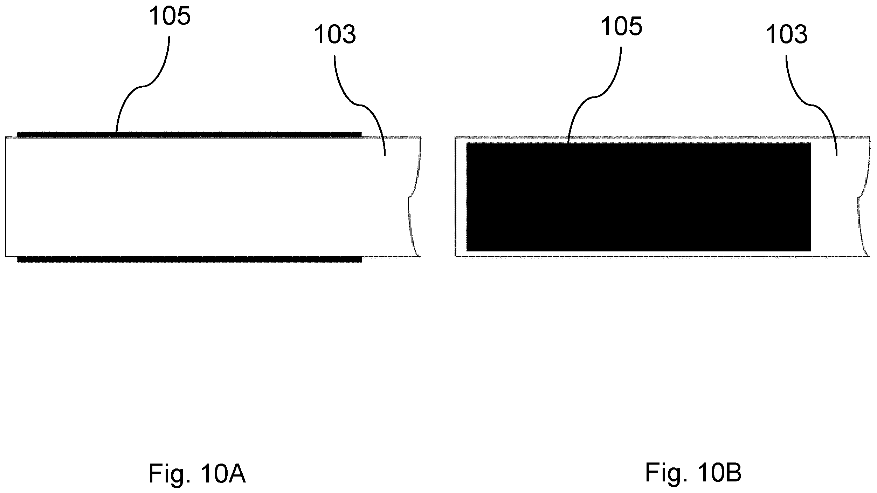

Fig. 10A zeigt eine Seitenansicht eines Kammzinkens 103, dessen elektrische Kontaktfläche 105 durch eine zweiseitige Kupferbeschichtung des Kammzinkens 103 gebildet ist. Eine Dicke der Kupferbeschichtung kann 35µm bis 105µm betragen. Ferner kann eine Dicke des Kammzinkens 103 1,5mm oder mehr betragen. Fig. 10B zeigt eine Aufsicht auf den in Fig. 10A abgebildeten Kammzinken 103. Gemäß einer Ausführungsform kann sich die elektrische Kontaktfläche 105 über die gesamte Breite des Kammzinkens 103 erstrecken. Beispielsweise erstreckt sich die elektrische Kontaktfläche 105 bis an die Ränder des Kammzinkens 103.

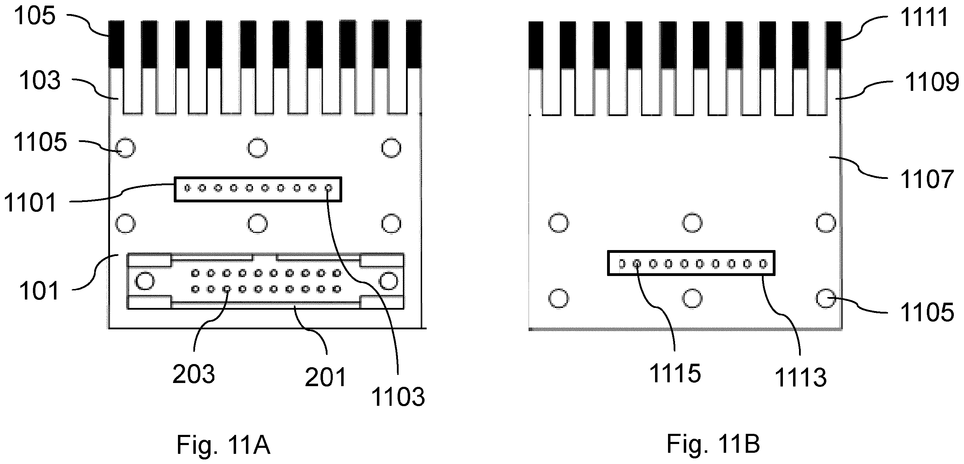

Fig. 11A zeigt eine Aufsicht auf die Leiterplatte 101 gemäß einer Ausführungsform. Die Leiterplatte 101 weist zehn Kammzinken 103, welche jeweils eine elektrische Kontaktfläche 105 aufweisen, eine elektrische Signalübertragungsschnittstelle 1101 mit zehn elektrischen Anschlüssen 1103 und sechs Öffnungen 1105 zum Befestigen eines Distanzbolzens auf. Ferner ist der Steckverbinder 201 mit zwanzig elektrischen Anschlüssen 203 an der Leiterplatte 101 angeordnet. Die elektrischen Anschlüsse 1103 können durch Durchkontaktierungen der Leiterplatte 101 gebildet sein.

Gemäß einer Ausführungsform kann die Leiterplatte 101 ferner 2, 4, 6, 8 oder 10 Öffnungen 1105 aufweisen, welche durch Bohrungen gebildet sein können.

Der Verbindungsadapter 100 kann ausgebildet sein mit der elektrischen Signalübertragungsschnittstelle 1101, insbesondere einer in oder an der Leiterplatte 101 gebildeten elektrischen Signalübertragungsschnittstelle 1101, wobei die elektrische Signalübertragungsschnittstelle 1101 mit der elektrischen Steckverbinderschnittstelle 107 elektrisch verbunden ist.

Fig. 11B zeigt eine Aufsicht auf eine weitere Leiterplatte 1107 gemäß einer Ausführungsform. Die weitere Leiterplatte 1107 weist zehn Kammzinken 1109, welche jeweils eine elektrische Kontaktfläche 1111 aufweisen, eine elektrische Signalübertragungsschnittstelle 1113 mit zehn elektrischen Anschlüssen 1115 und sechs Öffnungen 1105 zum Befestigen eines Distanzbolzens auf. Die elektrischen Anschlüsse 1115 können durch Durchkontaktierungen der weiteren Leiterplatte 1107 gebildet sein.

Gemäß einer Ausführungsform kann die weitere Leiterplatte 1107 ferner 2, 4, 6, 8 oder 10 Öffnungen 1105 aufweisen, welche durch Bohrungen gebildet sein können.

Der Verbindungsadapter 100 kann ausgebildet sein mit: der weiteren Leiterplatte 1107 mit einer kammförmigen Leitungsstruktur mit einer Mehrzahl von Kammzinken 1109, wobei die Kammzinken 1109 jeweils eine elektrische Kontaktfläche 1111 aufweisen; und einer weiteren elektrischen Signalübertragungsschnittstelle1113, insbesondere einer in oder an der weiteren Leiterplatte 1107 gebildeten weiteren elektrischen Signalübertragungsschnittstelle 1113, wobei die weitere Signalübertragungsschnittstelle 1113 mit der elektrischen Signalübertragungsschnittstelle 1101 der Leiterplatte 101 und mit den elektrischen Kontaktflächen 1111 der Kammzinken 1109 der weiteren Leiterplatte 1107 elektrisch verbunden ist.

Gemäß einer Ausführungsform können die elektrischen Anschlüssen 1103 mit den elektrischen Anschlüssen 1115 mittels einer Anschlussleitung, insbesondere mittels einer lötbaren Kabelverbindung verschiedener Polzahlen, oder einer Sandwichleiste elektrisch verbunden sein. Hierdurch können die elektrischen Anschlüsse 203 des auf der Leiterplatte 101 angeordneten Steckverbinders 201 mit den elektrischen Kontaktflächen 1111 der weiteren Leiterplatte 1107 elektrisch verbunden werden. Beispielsweise wird die obere Reihe der elektrischen Anschlüsse 203, welche einen Pin 1 umfassen kann, mit den elektrischen Kontaktflächen 1111 und die untere Reihe der elektrischen Anschlüsse 203, welche einen Pin 2 umfassen kann, mit den elektrischen Kontaktflächen 105 elektrisch verbunden.

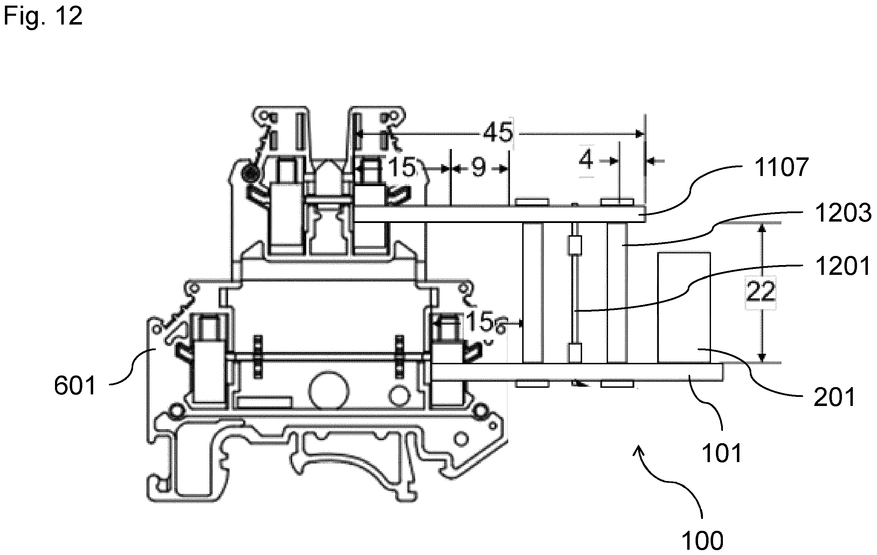

Fig. 12 zeigt eine Querschnittsansicht einer Anordnung mit einer Mehrzahl von doppelstöckigen Reihenklemmen 601 und dem Verbindungsadapter 100 gemäß einer weiteren Ausführungsform. Der Verbindungsadapter 100 umfasst die Leiterplatte 101 mit der nicht abgebildeten elektrischen Signalübertragungsschnittstelle 1101, die weitere Leiterplatte 1107 mit der nicht abgebildeten weiteren elektrischen Signalübertragungsschnittstelle 1113, einer Sandwichleiste 1201, welche die elektrische Signalübertragungsschnittstelle 1101 und die weitere elektrische Signalübertragungsschnittstelle 1113 elektrisch verbindet, und Distanzbolzen 1203, welche die Leiterplatte 101 mit der weiteren Leiterplatte 1107 mechanisch verbinden. Ferner sind Dimensionen und Abmessungen in der Einheit Millimeter abgebildet.

Die Sandwichleiste 1201 kann eine Mehrzahl von Kontaktstiften umfassen. Ferner können die Kontaktstifte der Sandwichleiste 1201 mit den nicht abgebildeten elektrischen Anschlüssen 1103, 1115 verlötet sein. Ferner können die Distanzbolzen 1203 Kunststoffbolzen sein. Die Distanzbolzen 1203 können ferner jeweils mit der Leiterplatte 101 und der weiteren Leiterplatte 1107 verschraubt sein. Beispielsweise werden hierzu Schrauben durch die nicht abgebildeten Öffnungen 1105 geführt.

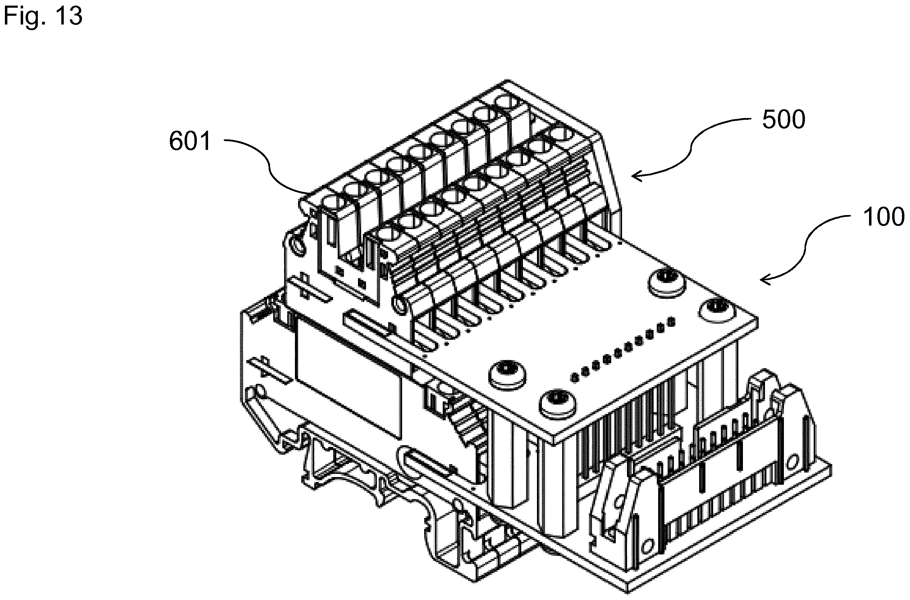

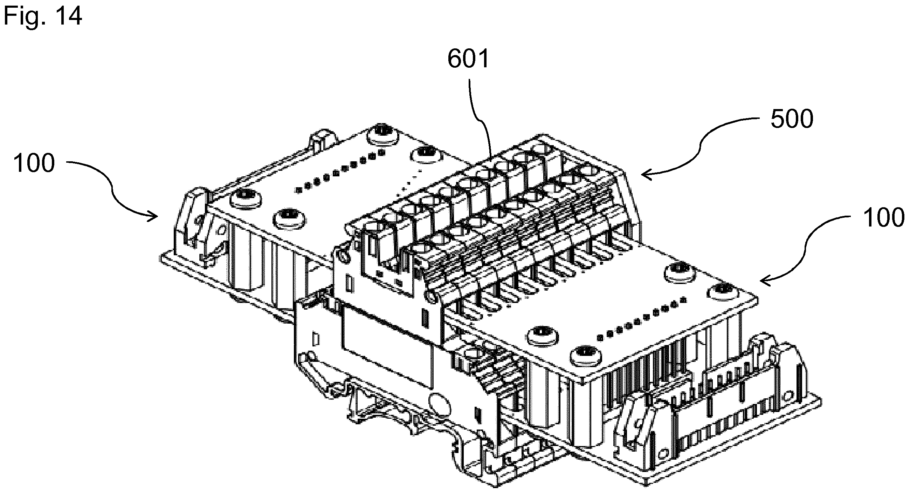

Fig. 13 zeigt eine perspektivische Ansicht der in Fig. 12 gezeigten Anordnung. Die Anschlussklemmenanordnung 500 ist durch eine Anordnung von doppelstöckigen Reihenklemmen 601 gebildet. Ferner zeigt Fig. 14 eine perspektivische Ansicht der in Fig. 12 gezeigten Anordnung mit einem weiteren Verbindungsadapter 100.

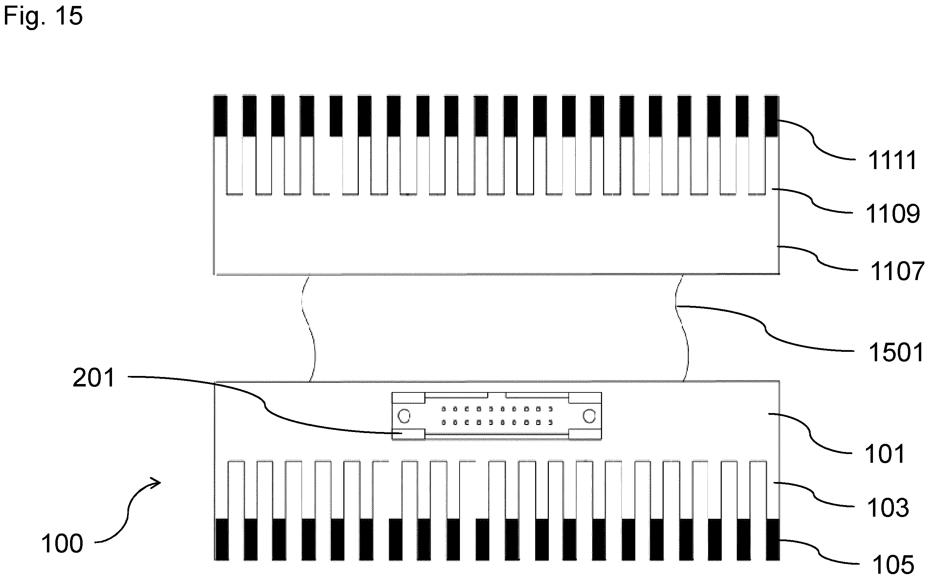

Fig. 15 zeigt eine schematische Darstellung des Verbindungsadapters 100 gemäß einer weiteren Ausführungsform. Der Verbindungsadapter 100 umfasst die Leiterplatte 101, die weitere Leiterplatte 1107 und einen flexiblen Leiterplattenabschnitt 1501, welcher die Leiterplatte 101 und die weitere Leiterplatte 1107 mechanisch und elektrisch verbindet. Die Leiterplatte 101 weist ferner Kammzinken 103 mit elektrischen Kontaktflächen 105 auf. Ferner ist an der Leiterplatte 101 der Steckverbinder 201 angeordnet. Die weitere Leiterplatte 1107 weist ferner Kammzinken 1109 mit elektrischen Kontaktflächen 1111 auf. Mittels des flexiblen Leiterplattenanteils 1501 können ferner die nicht abgebildete elektrische Signalübertragungsschnittstelle 1101 der Leiterplatte 101 und die nicht abgebildete weitere elektrische Signalübertragungsschnittstelle 1113 der weiteren Leiterplatte 1107 elektrisch verbunden werden. Hierzu kann der flexible Leiterplattenanteil 1501 Leiterbahnen aufweisen. Ferner kann mittels des flexiblen Leiterplattenanteils 1501 ein Ausgleich von seitlichem Versatz und/oder von Höhenunterschiede von einzelnen Etagen einer mehrstöckigen Anschlussklemmenanordnung 500 ermöglicht werden.

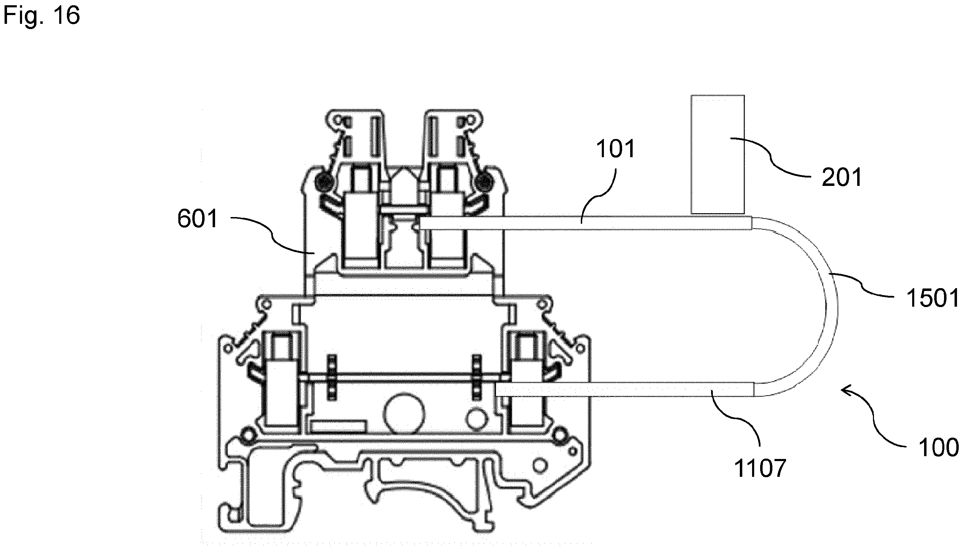

Fig. 16 zeigt eine Querschnittsansicht einer Anordnung mit der in Fig. 6 gezeigten doppelstöckigen Reihenklemme 601 und dem Verbindungsadapter 100 gemäß der in Fig. 15 gezeigten Ausführungsform. Der Verbindungsadapter 100 umfasst die Leiterplatte 101, auf welcher der Steckverbinder 201 angeordnet ist, den flexiblen Leiterplattenanteil 1501 und die weitere Leiterplatte 1107. Der Verbindungsadapter 100 ist an der doppelstöckigen Reihenklemme 601 angeschlossen.

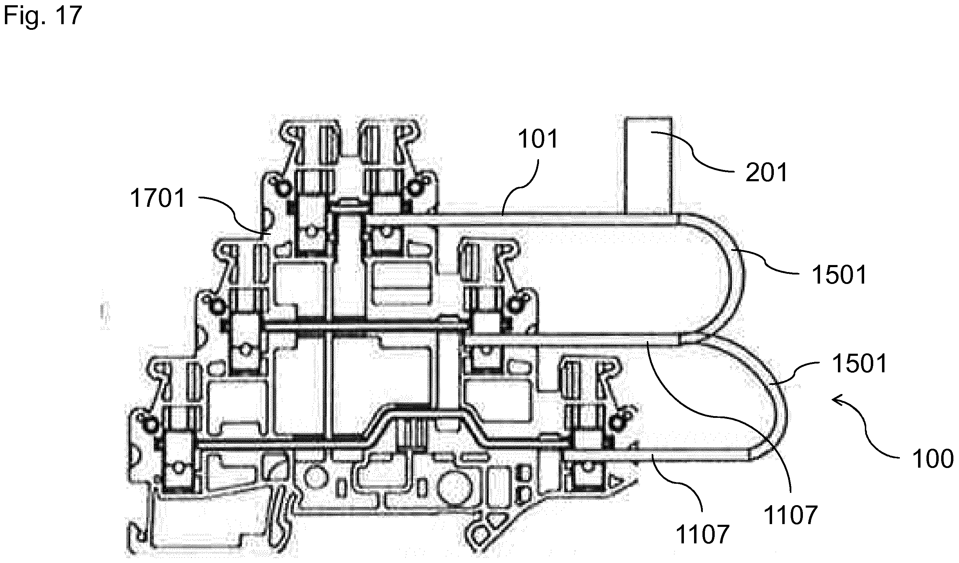

Fig. 17 zeigt eine Querschnittsansicht einer Anordnung mit einer dreistöckigen Reihenklemme 1701 und dem Verbindungsadapter 100 gemäß einer weiteren Ausführungsform. Der Verbindungsadapter 100 umfasst die Leiterplatte 101, auf welcher der Steckverbinder 201 angeordnet ist, zwei flexible Leiterplattenanteile 1501 und zwei weitere Leiterplatten 1107. Ferner ist der Verbindungsadapter 100 an der dreistöckigen Reihenklemme 1701 angeschlossen.

Gemäß einer Ausführungsform können zwei flexible Leiterplattenanteile 1501 mit einer weiteren Leiterplatte 1107 mechanisch und elektrisch verbunden werden. Hierzu kann jeweils ein flexibler Leiterplattenanteil 1501 von oben und ein flexibler Leiterplattenanteil 1501 von unten mit der weiteren Leiterplatte 1107 laminiert werden.

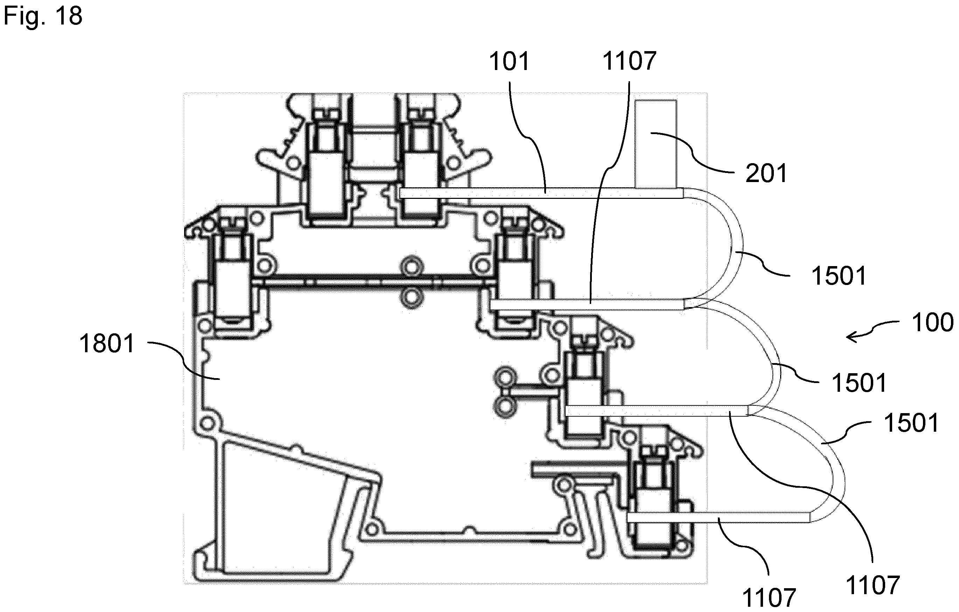

Fig. 18 zeigt eine Querschnittsansicht einer Anordnung mit einer vierstöckigen Reihenklemme 1801 und dem Verbindungsadapter 100 gemäß einer weiteren Ausführungsform. Der Verbindungsadapter 100 umfasst die Leiterplatte 101, auf welcher der Steckverbinder 201 angeordnet ist, drei flexible Leiterplattenanteile 1501 und drei weitere Leiterplatten 1107. Ferner ist der Verbindungsadapter 100 an der vierstöckigen Reihenklemme 1701 angeschlossen.

Alle in Verbindung mit einzelnen Ausführungsformen der Erfindung erläuterten und gezeigten Merkmale können in unterschiedlicher Kombination in dem erfindungsgemäßen Gegenstand vorgesehen sein, um gleichzeitig deren vorteilhafte Wirkungen zu realisieren.

### BEZUGSZEICHENLISTE

- 100: Verbindungsadapter
- 101: Leiterplatte
- 103: Kammzinken
- 105: Elektrische Kontaktfläche
- 107: Elektrische Steckverbinderschnittstelle
- 109: Elektrischer Anschluss
- 111: Öffnung
- 113: Beschriftungsfeld
- 115: Markierungsfeld
- 117: Bohrung

- 201: Steckverbinder
- 203: Elektrischer Anschluss

- 401: Bohrung

- 500: Anschlussklemmenanordnung
- 501: Reihenklemme
- 503: Elektrische Anschlussklemme

- 601: Doppelstöckige Reihenklemme
- 603: Schraube

- 901: Elektrisch leitender Steg

- 1101: Elektrische Signalübertragungsschnittstelle
- 1103: Elektrischer Anschluss
- 1105: Öffnung
- 1107: Weitere Leiterplatte
- 1109: Kammzinken
- 1111: Kontaktfläche
- 1113: Weitere elektrische Signalübertragungsschnittstelle
- 1115: Elektrischer Anschluss

- 1201: Sandwichleiste
- 1203: Distanzbolzen

- 1501: Flexibler Leiterplattenanteil

- 1701: Dreistöckige Reihenklemme

- 1801: Vierstöckige Reihenklemme

## Patentansprüche

1. Verbindungsadapter (100) für eine Anschlussklemmenanordnung (500), wobei die Anschlussklemmenanordnung (500) eine Anzahl von elektrischen Anschlussklemmen (503) aufweist, mit:
einer Leiterplatte (101) mit einer kammförmigen Leitungsstruktur mit der Anzahl von Kammzinken (103), wobei die Kammzinken (103) jeweils eine elektrische Kontaktfläche (105) aufweisen;
einer elektrischen Steckverbinderschnittstelle (107) für einen Steckverbinder, wobei die elektrische Steckverbinderschnittstelle (107) elektrische Anschlüsse (109) aufweist, welche mit den elektrischen Kontaktflächen (105) der Kammzinken (107) elektrisch verbunden sind, und wobei die elektrische Steckverbinderschnittstelle (107) auf der Leiterplatte (101) angeordnet ist;
**gekennzeichnet durch**
eine elektrische Signalübertragungsschnittstelle (1101), insbesondere eine in oder an der Leiterplatte (101) gebildete elektrische Signalübertragungsschnittstelle (1101), wobei die elektrische Signalübertragungsschnittstelle (1101) mit der elektrischen Steckverbinderschnittstelle (107) elektrisch verbunden ist;
eine weitere Leiterplatte (1107) mit einer kammförmigen Leitungsstruktur mit einer Mehrzahl von Kammzinken (1109), wobei die Kammzinken (1109) jeweils eine elektrische Kontaktfläche (1111) aufweisen; und
eine weitere elektrische Signalübertragungsschnittstelle (1113), insbesondere eine in oder an der weiteren Leiterplatte (1107) gebildete weitere elektrische Signalübertragungsschnittstelle (1113), wobei die weitere Signalübertragungsschnittstelle (1113) mit der elektrischen Signalübertragungsschnittstelle (1101) der Leiterplatte (101) und mit den elektrischen Kontaktflächen (1111) der Kammzinken (1109) der weiteren Leiterplatte (1107) elektrisch verbunden ist,
wobei die Leiterplatte (101) und die weitere Leiterplatte (1107) übereinander und voneinander beabstandet angeordnet sind, und wobei die Leiterplatte (101) und die weitere Leiterplatte (1107) mittels eines Distanzbolzens (1203) voneinander beabstandet angeordnet sind.

2. Verbindungsadapter (100) nach Anspruch 1, wobei jeweils eine elektrische Kontaktfläche (105) eines Kammzinkens (103) der Leiterplatte (101) mit jeweils einem elektrischen Anschluss (109) der elektrischen Steckverbinderschnittstelle (107) elektrisch verbunden ist.

3. Verbindungsadapter (100) nach Anspruch 1 oder 2, mit einem Steckverbinder (201), insbesondere mit einem FLK-Steckverbinder oder einem D-Sub-Steckverbinder, wobei der Steckverbinder (201) mit den elektrischen Anschlüssen (109) der elektrischen Steckverbinderschnittstelle (107) elektrisch verbunden ist.

4. Verbindungsadapter (100) nach Anspruch 3, wobei der Steckverbinder (201) kraftschlüssig oder formschlüssig mit der Leiterplatte (101) verbunden ist.

5. Verbindungsadapter (100) nach einem der vorangehenden Ansprüche, wobei die Kammzinken (103) der Leiterplatte (101) rechteckförmig oder abgerundet sind.

6. Verbindungsadapter (100) nach einem der vorangehenden Ansprüche, wobei benachbarte Kammzinken (103) der Leiterplatte (101) durch eine Ausnehmung, insbesondere durch eine rechteckförmige oder abgerundete Ausnehmung, beabstandet sind, welche ausgebildet ist, einen Gehäusesteg der Anschlussklemmenanordnung (500) zwischen benachbarten elektrischen Anschlussklemmen (503) aufzunehmen.

7. Verbindungsadapter (100) nach einem der vorangehenden Ansprüche, wobei eine elektrische Kontaktfläche (105) eines Kammzinkens (103) der Anzahl der Kammzinken (103) der Leiterplatte (101) eine Rechteckform, eine Quadratform, eine Kreisform, eine Dreiecksform oder eine Fünfeckform aufweist.

8. Verbindungsadapter (100) nach einem der vorangehenden Ansprüche, wobei die weitere Signalübertragungsschnittstelle (1113) über eine Sandwichleiste (1201) oder einen flexiblen Leiterplattenanteil (1501), insbesondere einen bogenförmigen oder S-förmigen flexiblen Leiterplattenanteil (1501), mit der elektrischen Signalübertragungsschnittstelle (1101) elektrisch verbunden ist.

9. Verbindungsadapter (100) nach einem der vorangehenden Ansprüche, wobei jeweils eine elektrische Kontaktfläche (1111) eines Kammzinkens (1109) der weiteren Leiterplatte (1107) mit jeweils einem elektrischen Anschluss (109) der elektrischen Steckverbinderschnittstelle (107) elektrisch verbunden ist.

10. Verbindungsadapter (100) nach einem der vorangehenden Ansprüche, mit:
einer weiteren Anzahl von weiteren Leiterplatten (1107), wobei jede Leiterplatte (1107) eine kammförmige Leitungsstruktur mit einer Mehrzahl von Kammzinken (1109) mit jeweils einer elektrische Kontaktfläche (1111) sowie eine elektrische Signalübertragungsschnittstelle (1113) aufweist, und wobei die elektrischen Kontaktflächen (1111) zumindest einer Leiterplatte (1107) der weiteren Anzahl der weiteren Leiterplatten (1107) mit der elektrischen Signalübertragungsschnittstelle (1113) dieser Leiterplatte (1107) verbunden sind.

11. Verbindungsadapter (100) nach Anspruch 10, wobei jeweils eine elektrische Kontaktfläche (1111) eines Kammzinkens (1109) der weiteren Anzahl der weiteren Leiterplatten (1107) mit jeweils einem elektrischen Anschluss (109) der elektrischen Steckverbinderschnittstelle (107) elektrisch verbunden ist.

## Claims

1. Connecting adapter (100) for a connection terminal assembly (500), wherein the connection terminal assembly (500) has a number of electrical connection terminals (503), said connecting adapter comprising:
a printed circuit board (101) with a comb-shaped conductor structure comprising the number of comb tines (103), wherein the comb tines (103) each have an electrical contact surface (105);
an electrical connector interface (107) for a connector, wherein the electrical connector interface (107) has electrical terminals (109) which are electrically connected to the electrical contact surfaces (105) of the comb tines (107), and wherein the electrical connector interface (107) is arranged on the printed circuit board (101);
**characterized by**
an electrical signal transmission interface (1101), in particular an electrical signal transmission interface (1101) formed in or on the printed circuit board (101), wherein the electrical signal transmission interface (1101) is electrically connected to the electrical connector interface (107);
a further printed circuit board (1107) with a comb-shaped conductor structure comprising a plurality of comb tines (1109), wherein the comb tines (1109) each have an electrical contact surface (1111); and
a further electrical signal transmission interface (1113), in particular a further electrical signal transmission interface (1113) formed in or on the further printed circuit board (1107), wherein the further signal transmission interface (1113) is electrically connected to the electrical signal transmission interface (1101) of the printed circuit board (101) and to the electrical contact surfaces (1111) of the comb tines (1109) of the further printed circuit board (1107),
wherein the printed circuit board (101) and the further printed circuit board (1107) are arranged one above the other and at a distance from one another, and wherein the printed circuit board (101) and the further printed circuit board (1107) are arranged at a distance from one another by means of a spacer bolt (1203).

2. Connecting adapter (100) according to claim 1, wherein a respective electrical contact surface (105) of a comb tine (103) of the printed circuit board (101) is electrically connected to a respective electrical terminal (109) of the electrical connector interface (107).

3. Connecting adapter (100) according to claim 1 or 2, comprising a connector (201), in particular an FLK connector or a D-Sub connector, wherein the connector (201) is electrically connected to the electrical terminals (109) of the electrical connector interface (107).

4. Connecting adapter (100) according to claim 3, wherein the connector (201) is connected to the printed circuit board (101) in a force-fitting or form-fitting manner.

5. Connecting adapter (100) according to one of the preceding claims, wherein the comb tines (103) of the printed circuit board (101) are rectangular or rounded.

6. Connecting adapter (100) according to one of the preceding claims, wherein adjacent comb tines (103) of the printed circuit board (101) are spaced apart by a recess, in particular by a rectangular or rounded recess, which is designed to receive a housing web of the connection terminal assembly (500) between adjacent electrical connection terminals (503).

7. Connecting adapter (100) according to one of the preceding claims, wherein an electrical contact surface (105) of a comb tine (103) of the number of comb tines (103) of the printed circuit board (101) has a rectangular shape, a square shape, a circular shape, a triangular shape or a pentagonal shape.

8. Connecting adapter (100) according to one of the preceding claims, wherein the further signal transmission interface (1113) is electrically connected to the electrical signal transmission interface (1101) via a sandwich strip (1201) or a flexible printed circuit board portion (1501), in particular a curved or S-shaped flexible printed circuit board portion (1501).

9. Connecting adapter (100) according to one of the preceding claims, wherein a respective electrical contact surface (1111) of a comb tine (1109) of the further printed circuit board (1107) is electrically connected to a respective electrical terminal (109) of the electrical connector interface (107).

10. Connecting adapter (100) according to one of the preceding claims, comprising:
an additional number of further printed circuit boards (1107), wherein each printed circuit board (1107) has a comb-shaped conductor structure comprising a plurality of comb tines (1109), each having an electrical contact surface (1111), and an electrical signal transmission interface (1113), and wherein the electrical contact surfaces (1111) of at least one printed circuit board (1107) of the additional number of further printed circuit boards (1107) are connected to the electrical signal transmission interface (1113) of said printed circuit board (1107).

11. Connecting adapter (100) according to claim 10, wherein a respective electrical contact surface (1111) of a comb tine (1109) of the additional number of further printed circuit boards (1107) is electrically connected to a respective electrical terminal (109) of the electrical connector interface (107).

## Revendications

1. Adaptateur de connexion (100) pour un ensemble de bornes de connexion (500), ledit ensemble de bornes de connexion (500) comprenant une pluralité de bornes de connexion (503) électriques, avec :
une carte à circuit imprimé (101) ayant une structure conductrice en forme de peigne comportant la pluralité de dents de peigne (103), lesdites dents de peigne (103) présentant chacune une surface de contact électrique (105) ;
une interface de connecteur électrique (107) pour un connecteur, ladite interface de connecteur électrique (107) présentant des connexions électriques (109) électriquement reliées aux surfaces de contact électriques (105) des dents de peigne (107), et ladite interface de connecteur électrique (107) étant disposée sur la carte à circuit imprimé (101) ;
**caractérisé par**
une interface de transmission de signal électrique (1101), en particulier une interface de transmission de signal électrique (1101) formée dans ou sur la carte à circuit imprimé (101), ladite interface de transmission de signal électrique (1101) étant électriquement reliée à l'interface de connecteur électrique (107) ;
une autre carte à circuit imprimé (1107) ayant une structure conductrice en forme de peigne comportant une pluralité de dents de peigne (1109), lesdites dents de peigne (1109) présentant chacune une surface de contact électrique (1111) ; et
une autre interface de transmission de signal électrique (1113), en particulier une autre interface de transmission de signal électrique (1113) formée dans ou sur l'autre carte à circuit imprimé (1107), ladite autre interface de transmission de signal (1113) étant électriquement reliée à l'interface de transmission de signal électrique (1101) de la carte à circuit imprimé (101) et aux surfaces de contact électriques (1111) des dents de peigne (1109) de l'autre carte à circuit imprimé (1107),
la carte à circuit imprimé (101) et l'autre carte à circuit imprimé (1107) étant disposées l'une au-dessus de l'autre et espacées l'une de l'autre, et la carte à circuit imprimé (101) et l'autre carte à circuit imprimé (1107) étant espacées l'une de l'autre au moyen d'une colonnette (1203).

2. Adaptateur de connexion (100) selon la revendication 1, où chaque surface de contact électrique (105) d'une dent de peigne (103) de la carte à circuit imprimé (101) est électriquement reliée à une connexion électrique (109) respective de l'interface de connecteur électrique (107).

3. Adaptateur de connexion (100) selon la revendication 1 ou la revendication 2, comprenant un connecteur (201), en particulier un connecteur FLK ou un connecteur D-sub, ledit connecteur (201) étant électriquement relié aux connexions électriques (109) de l'interface de connecteur électrique (107).

4. Adaptateur de connexion (100) selon la revendication 3, où le connecteur (201) est raccordé par adhérence ou par engagement positif à la carte à circuit imprimé (101).

5. Adaptateur de connexion (100) selon l'une des revendications précédentes, où les dents de peigne (103) de la carte à circuit imprimé (101) sont rectangulaires ou arrondies.

6. Adaptateur de connexion (100) selon l'une des revendications précédentes, où des dents de peigne (103) contiguës de la carte à circuit imprimé (101) sont espacées d'un évidement, en particulier un évidement rectangulaire ou arrondi, prévu pour recevoir une barrette du boîtier de l'ensemble de bornes de connexion (500) entre des bornes de connexion électriques (503) contiguës.

7. Adaptateur de connexion (100) selon l'une des revendications précédentes, où une surface de contact électrique (105) d'une dent de peigne (103) de la pluralité de dents de peigne (103) de la carte à circuit imprimé (101) a une forme rectangulaire, carrée, circulaire, triangulaire ou une forme pentagonale.

8. Adaptateur de connexion (100) selon l'une des revendications précédentes, où l'autre interface de transmission de signal (1113) est électriquement reliée à l'interface de transmission de signal électrique (1101) par une barrette sandwich (1201) ou un élément flexible de carte à circuit imprimé (1501), en particulier un élément de carte à circuit imprimé (1501) en forme d'arc ou de S.

9. Adaptateur de connexion (100) selon l'une des revendications précédentes, où chaque surface de contact électrique (1111) d'une dent de peigne (1109) de l'autre carte à circuit imprimé (1107) est électriquement reliée à une connexion électrique (109) respective de l'interface de connecteur électrique (107).

10. Adaptateur de connexion (100) selon l'une des revendications précédentes, comprenant :
une autre pluralité d'autres cartes à circuit imprimé (1107), chaque carte à circuit imprimé (1107) ayant une structure conductrice en forme de peigne comportant une pluralité de dents de peigne (1109) présentant chacune une surface de contact électrique (1111) ainsi qu'une interface de transmission de signal électrique (1113), et les surfaces de contact électriques (1111) d'au moins une carte à circuit imprimé (1107) de l'autre pluralité d'autres cartes à circuit imprimé (1107) étant reliées à l'interface de transmission de signal électrique (1113) de ladite carte à circuit imprimé (1107).

11. Adaptateur de connexion (100) selon la revendication 10, où chaque surface de contact électrique (1111) d'une dent de peigne (1109) de l'autre pluralité d'autres cartes à circuit imprimé (1107) est électriquement reliée à une connexion électrique (109) respective de l'interface de connecteur électrique (107).
